# EUROPÄISCHE PATENTANMELDUNG

(11) **EP 2 604 969 A1**
(43) Veröffentlichungstag der Anmeldung: **19.06.2013**
(21) Anmeldenummer: 11009889.4
(22) Anmeldetag: 15.12.2011
(51) Int. Cl.: F41H 5/26

(54) **Winkelspiegel für Panzerfahrzeuge**

(71) Anmelder: GuS Präzision in Kunstoff Glas und Optik GmbH & Co. KG, 32312 Lübbecke (DE)
(72) Erfinder: Kuhnke, Dieter, 32312 Lübbecke (DE)
(74) Vertreter: Rolf, Gudrun

(57) **Zusammenfassung**

Es wird eine Winkelspiegel eines gepanzerten Fahrzeugs, aus einem Gehäuse (2;22) mit einer Einblicköffnung (3) eines sich in einen Fahrzeuginnenraum (6) erstreckenden Teilbereichs und einer Ausblicköffnung (4) eines sich aus dem Fahrzeug heraus erstreckenden Teilbereichs sowie mit mindestens einem im Gehäuse (2;22) angeordneten Prismenkörper (5;15) oder Umlenkspiegeln zur Verfügung gestellt, der eine wirksame Abschirmung vor elektromagnetischen Störquellen bietet, so dass damit ausgestattete Fahrzeuge bzw. deren einzelnen elektronischen Komponenten nicht durch elektromagnetische Störquellen beeinflusst oder unbrauchbar gemacht werden können, was dadurch erzielt wird, dass der Winkelspiegel (1;21) allseitig mit einer Abschirmung aus elektrisch leitendem Material versehen ist.

## Beschreibung

Die Erfindung betrifft einen Winkelspiegel eines gepanzerten Fahrzeuges gemäß dem Oberbegriff des ersten Patentanspruches.

Es ist ein Winkelspiegel eines Panzerfahrzeuges bekannt, DE 20 2006 004 545 U1, der einen Laserstrahlenschutzfilter aufweist, um einen im Fahrzeuginneren durch einen Winkelspiegel nach außen blickenden Fahrzeugführer vor Blendung zu schützen.

Nachteilig an einem solchen bekannten Winkelspiegel ist, dass er das damit ausgestattete Fahrzeug nicht vor elektromagnetischen Störquellen eines Angreifers schützt, so dass dadurch das Fahrzeug selber oder dessen einzelnen elektronischen Komponenten beschädigt oder gestört werden können.

Aufgabe der Erfindung ist es, einen Winkelspiegel zur Verfügung zu stellen, der eine wirksame Abschirmung vor elektromagnetischen Störquellen bietet, so dass damit ausgestattete Fahrzeuge bzw. deren einzelnen elektronischen Komponenten nicht durch elektromagnetische Störquellen beeinflusst oder unbrauchbar gemacht werden können.

Die Lösung dieser Aufgabe erfolgt in Verbindung mit den Oberbegriffsmerkmalen erfindungsgemäß im Zusammenhang mit den kennzeichnenden Merkmalen des ersten Hauptanspruches.

Ein Winkelspiegel eines gepanzerten Fahrzeuges, aus einem Gehäuse mit eine Einblicköffnung eines sich in einem Fahrzeuginnenraum erstreckenden Teilbereichs und einer Ausblicköffnung eines sich aus dem Fahrzeug heraus erstreckenden Teilbereichs sowie mit mindestens einem im Gehäuse angeordneten Prismenkörper oder Umlenkspiegeln wird zum Schutz vor Beschädigung oder Störung des Fahrzeuges oder dessen elektronischen Komponenten gegen elektromagnetische Störquellen mit einer vollflächigen Abschirmung aus elektrisch leitenden Materialien versehen. Hierdurch wird erreicht, dass elektromagnetische Störquellen nicht durch die Fahrzeughülle in das gepanzerte Fahrzeug eindringen können, so dass insbesondere elektronische Komponenten nicht durch solche Störquellen eines Gegners in ihrer Funktion beeinträchtigt werden können.

Erfinderische Ausgestaltungen des Gegenstandes der Erfindung ergeben sich aus und in Kombination mit den nachfolgenden Unteransprüchen.

Bei einer vorteilhaften Ausgestaltung der Erfindung ist das elektrisch leitende Material entweder vor der Einblicköffnung auf dem zu dem Fahrzeuginnenraum gerichteten Teilbereich oder vor der Ausblicköffnung auf dem sich aus dem Fahrzeug heraus erstreckenden Teilbereich oder auch im Strahlengang des Winkelspiegels, etwa zwischen zwei separaten Prismenblöcken, angeordnet, sodass eine optimale Position der Abschirmung gewählt werden kann. Eine Ausführungsform mit vor der Ausblicköffnung angeordneter Abschirmung schützt bereits elektronische Bauteile des Winkelspiegels selber, wie z.B. elektronische Displays, deren Anzeigen in die Einblickseite eingespiegelt werden.

Der Winkelspiegel kann weiterhin vorteilhaft auch mit mehreren identischen oder unterschiedlichen elektromagnetischen Abschirmungen versehen sein, um seine Abschirmleistung weiter zu verbessern.

Eine bevorzugte Ausführungsform des Gegenstandes der Erfindung ist als Abschirmung des Gehäuses mit einem Netzgewebe, auch Mesh- oder Quadrat-Gitter-Gewebe genannt, aus feinsten leitenden Fäden ausgestattet, die jeweils aus einem metallischen Draht bestehen können, der eine Stärke von nur 20 bis 80 µm besitzen kann, wobei das Netzgewebe zwischen 25 und 250, insbesondere 50 Öffnungen pro Inch, bzw. 10 bis 100, insbesondere 20 Öffnungen pro cm aufweist, so dass eine Lichttransmission von mehr als 85 % erhalten bleibt, aber in einem Frequenzbereich von 1 MHz bis zu 10 GHz eine Schirmdämpfung von 100 bis 37 db erreicht wird. Durch eine Variation der Drahtstärken und/ oder der Anzahl der Öffnungen lässt sich die Schirmdämpfung auch auf bekannte elektromagnetische Störquellen anpassen.

Zum Schutz des extrem feinen Netzgewebes ist dieses bevorzugt zwischen zwei Scheiben in einer Verbundscheibe verpresst, wobei die Scheiben der Verbundscheibe aus Glas oder Kunststoff bestehen können und das Netz entweder in eine Schmelzfolie eingebettet ist oder zwischen zwei Kunststoffscheiben heiß verpresst ist.

Um einen sicheren Kontakt des Netzgewebes mit dem Gehäuse des Winkelspiegels zu erzeugen, steht das Netzgewebe mit einem als Kontaktrand ausgeführten Rand umlaufend über den Rand der Verbundscheiben hervor, so dass der Kontaktrand mit einem umlaufenden Kontakt zu einem leitenden Rahmen des Gehäuses verbaut ist, der seinerseits eine leitende Kontaktfläche mit dem Gehäuse des Winkelspiegels aufweist, ebenso wie dieser über eine leitfähige Dichtung eine leitende Verbindung zu der Fahrzeughülle erzeugt, so dass nur die definierten Öffnungen im Netzgewebe den vollflächigen Schutz der Fahrzeughülle beeinflussen.

Bei einer zweiten wesentlichen Ausführungsform des erfinderischen Winkelspiegels ist eine Scheibe im Bereich der Einblicköffnung mit einer transparenten, stromleitenden Beschichtung versehen, die ihrerseits über das Gehäuse des Winkelspiegels eine leitfähige Dichtung einen elektrisch leitenden Kontakt mit der Fahrzeughülle besitzt, so dass hierdurch die Außenhülle des Fahrzeuges sogar vollkommen gegen eindringende elektromagnetische Störstrahlung abgeschlossen ist.

Die Beschichtung kann dabei vorzugsweise aus einer Indium-Zinkoxid-Schicht, einer sogenannten ITO-Beschichtung, bestehen.

Als leitfähige Dichtung wird hier bevorzugt eine Dichtung aus Silikon mit Nickel-Graphit verwandt, die dauerhaft alle denkbaren Temperatur- und sonstige Umgebungseinflüsse mit hoher Widerstandskraft erträgt.

Die Oberfläche des sich in den Innenraum eines gepanzerten Fahrzeuges erstreckenden Teilbereich des Gehäuses und/ oder auch die Oberfläche des sich aus dem Fahrzeug heraus erstreckenden Teilbereichs des Gehäuses ist des weiteren vorteilhaft mit einer elektrisch leitfähigen Beschichtung versehen, wobei die Oberflächen des Gehäuses für eine bessere Leitfähigkeit chromatiert ausgeführt sind.

Vorteilhaft ist des Weiteren eine weitere Variationsmöglichkeit des erfinderischen Winkelspiegel, der bei vor der Einblicköffnung und/ oder vor der Ausblicköffnung und/ oder im Strahlengang des Winkelspiegels vorgesehenen Abschirmungen mit unterschiedlichen Abschirmungen ausgestattet sein kann, wie etwa mit Netzgeweben mit unterschiedlichen Dämpfungen oder mit unterschiedlichen transparenten stromleitenden Beschichtungen oder mit Kombinationen von solchen Netzgeweben und Beschichtungen.

Nachfolgend wird der erfinderische Winkelspiegel anhand von Zeichnungen näher beschrieben. Es zeigen:
- Fig. 1: eine Seitenansicht eines Winkelspiegels,
- Fig. 2: eine linke Teilansicht eines Winkelspiegels mit einem Netzgewebe vor seiner Einblicköffnung,
- Fig. 3: eine rechte Teilansicht eines Winkelspiegels mit einer elektrisch leitenden Beschichtung einer Scheibe seiner Einblicköffnung,
- Fig. 4: eine Seitenansicht einer zweiten Winkelspiegelvariation mit einem Netzgewebe vor ihrer Ausblicköffnung und im Strahlengang,

- Fig. 5: eine linke Teilansicht eines Winkelspiegels mit einem Netzgewebe vor seiner Ausblicköffnung, und
- Fig. 6: eine rechte Teilansicht eines Winkelspiegels mit einer elektrisch leitenden Beschichtung einer Scheibe vor seine Ausblicköffnung.

Der Winkelspiegel 1;21 eines gepanzerten Fahrzeuges besteht aus einem Gehäuse 2;22 mit einer Einblicköffnung 3 eines sich in einen Fahrzeuginnenraum 6 erstreckenden Teilbereiches und einer Ausblicköffnung 4 eines sich aus dem Fahrzeug heraus erstreckenden Teilbereichs, sowie aus einem im Gehäuse 2;22 angeordneten Prismenkörper 5;15, wobei sich der aus dem Fahrzeug herauserstreckende Teilbereich des Winkelspiegel 1;21 die Fahrzeughülle 13 durchdringt und über eine leitfähige Dichtung 12, etwa aus Silikon mit Nickel-Graphit, abdichtet.

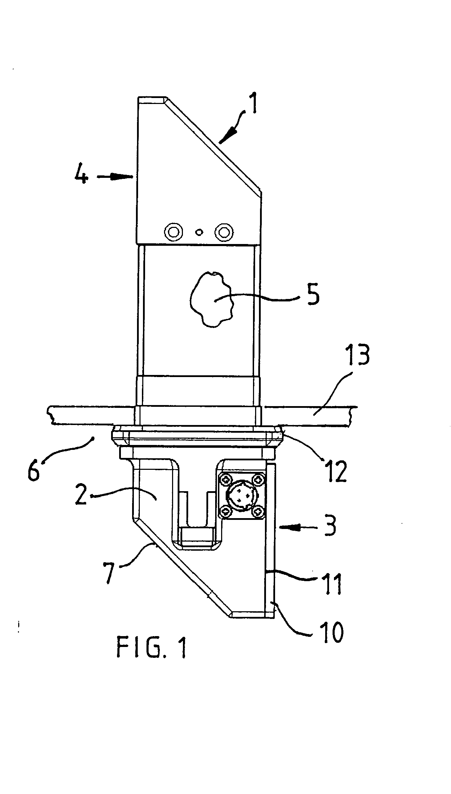

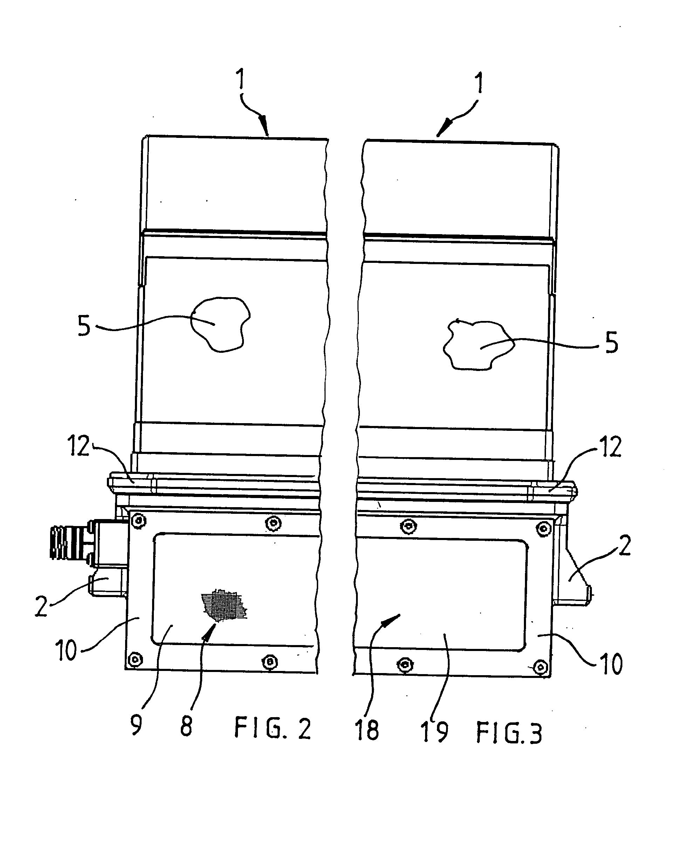

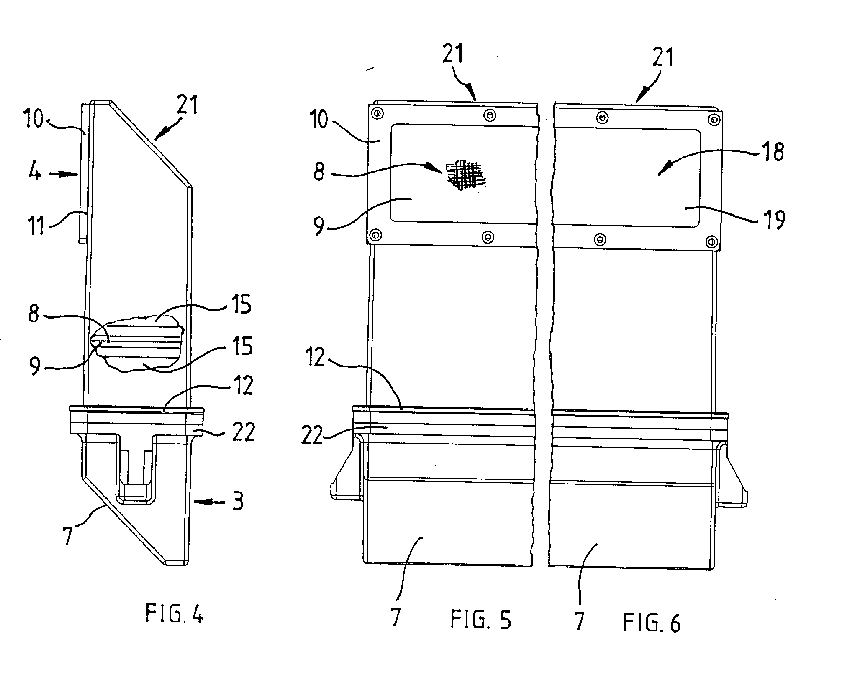

Eine erste Ausführungsform weist, wie in den Figuren 1 und 2 dargestellt, eine Einblicköffnung 3 des Winkelspiegels 1 auf, vor der ein Netzgewebe 8 aus feinsten leitenden Fäden angeordnet ist, die aus dünnem metallischen Draht bestehen und eine Stärke von etwa 20 bis 80 µm besitzen. Die Figuren 4 und 5 zeigen ein solches Netzgewebe 8 vor einem Ausblick 4 eines Winkelspiegels 21.

Zwischen den feinen Drähten des Netzgewebes 8 ist eine definierte Anzahl von Öffnungen vorgesehen, um Licht durch das Netzgewebe 8 hindurch treten zu lassen, wobei etwa 25 bis 250, insbesondere 50 Öffnungen pro Inch vorgesehen sein können, was 10 bis 100, insbesondere 20 Öffnungen pro cm entspricht, so dass eine Lichttransmission über 85 % möglich ist, wodurch eine Schirmdämpfung von 10 bis 37 db in einem Frequenzbereich von 1 MHz von bis zu 10 GHz erreicht werden kann.

Das Netzgewebe 8 ist zwischen zwei Scheiben zu einer Verbundscheibe 9 verpresst, wobei insbesondere dann, wenn die Scheiben aus Glas bestehen, dass Netzgewebe 8 in eine Schmelzfolie eingebettet ist oder auch bei reinen Kunststoffscheiben das Netzgewebe zwischen zwei Kunststoffscheiben heiß verpresst eingebettet ist.

Das Netzgewebe 8 steht umlaufend über den Rand der Verbundscheiben 9 hervor und bildet so einen Kontaktrand, der mit einem umlaufenden Kontakt zu einem leitenden Rahmen 10 verbaut ist, der seinerseits eine leitende Kontaktfläche 11 mit dem Gehäuse 2;22 des Winkelspiegels 1;21 aufweist.

Eine zweite Ausführungsform des erfinderischen Winkelspiegels 1;21 ist, wie in den Figuren 3 und 6 dargestellt ist, im Bereich der Einblicköffnung 3 des Gehäuses 1 oder im Bereich der Ausblicköffnung 4 des Gehäuses 22 mit einer Scheibe 19 versehen, die mit einer transparenten stromleitenden Beschichtung 18 ausgestattet ist, die über das Gehäuse 2;22 des Winkelspiegels 1;21 und eine leitfähige Dichtung 12 ebenfalls einen leitenden elektrischen Kontakt mit der Fahrzeughülle 13 aufweist. Die transparente stromleitende Beschichtung 18 besteht hier aus einer Indium-Zinn-Oxid-Schicht (ITO-Beschichtung).

Wie in Figur 4 skizziert ist, kann die Abschirmung auch im Strahlengang des Winkelspiegels (1;21), etwa zwischen zwei separaten Prismenblöcken (15), angeordnet sein und wahlweise aus einem Netzgewebe 8 oder einer stromleitenden durchsichtigen Beschichtung 18 bestehen und jeweils einen elektrischen Kontakt mit dem Gehäuse 2;22 und der Fahrzeughülle 13 aufweisen.

Die Oberfläche 7 des sich in den Innenraum erstreckenden Teilbereichs des Gehäuses 2;22 ist ebenfalls mit einer elektrisch leitfähigen Beschichtung versehen, wobei die Oberflächen 7 des Gehäuses 2;22 für eine bessere Leitfähigkeit chromatiert ausgeführt sind.

## Patentansprüche

1. Winkelspiegel eines gepanzerten Fahrzeugs, aus einem Gehäuse (2;22) mit einer Einblicköffnung (3) eines sich in einen Fahrzeuginnenraum (6) erstreckenden Teilbereichs und einer Ausblicköffnung (4) eines sich aus dem Fahrzeug heraus erstreckenden Teilbereichs sowie mit mindestens einem im Gehäuse (2;22) angeordneten Prismenkörper (5;15) oder Umlenkspiegeln, **dadurch gekennzeichnet, dass** der Winkelspiegel (1;21) zum Schutz vor Beschädigung oder Störung des Fahrzeugs oder dessen elektronischen Komponenten gegen elektromagnetische Störquellen mit einer Abschirmung aus elektrisch leitendem Material versehen ist.

2. Winkelspiegel nach Anspruch 1, **dadurch gekennzeichnet, dass** das elektrisch leitende Material entweder vor der Einblicköffnung (3) auf dem zu dem Fahrzeuginnenraum (6) gerichteten Teilbereich oder vor der Ausblicköffnung (4) auf dem sich aus dem Fahrzeug heraus erstreckenden Teilbereich oder im Strahlengang des Winkelspiegels (1;21), etwa zwischen zwei separaten Prismenblöcken (5;15) angeordnet ist.

3. Winkelspiegel nach der vorgenannten Ansprüche, **dadurch gekennzeichnet, dass** er mit mehreren identischen oder unterschiedlichen elektromagnetischen Abschirmungen versehen ist.

4. Winkelspiegel nach der vorgenannten Ansprüche, **dadurch gekennzeichnet, dass** die Abschirmung aus einem Netzgewebe (8) aus feinsten leitenden Fäden besteht, das vor der Einblicköffnung (3) und/ oder vor der Ausblicköffnung (4). und/ oder im Strahlengang des Winkelspiegels (1;21) angeordnet ist.

5. Winkelspiegel nach Anspruch 4, **dadurch gekennzeichnet, dass** die Fäden des Netzgewebes (8) aus metallischem Draht und/ oder anderen stromleitenden Fasern, wie Kohlefasern, bestehen und eine Stärke von 20 bis 80 µm besitzen

6. Winkelspiegel nach Anspruch 4, **dadurch gekennzeichnet, dass** das Netzgewerbe (8) zwischen 25 und 250, insbesondere 50 Öffnungen pro Inch bzw. zwischen 10 und 100, insbesondere 20 Öffnungen pro cm mit einer Lichttransmission von mindestens 85% und in einem Frequenzbereich von 1 MHz bis 10 GHz eine Schirmdämpfung von 100 bis 37 db aufweist.

7. Winkelspiegel nach Anspruch 4, **dadurch gekennzeichnet, dass** das Netzgewebe (8) zwischen zwei Scheiben zu einer Verbundscheibe (9) verpresst ist.

8. Winkelspiegel nach Anspruch 7, **dadurch gekennzeichnet, dass** die Scheiben der Verbundscheibe (9) aus Glas oder Kunststoff bestehen und dass das Netzgewebe (8) in eine Schmelzfolie eingebettet ist.

9. Winkelspiegel nach Anspruch 7, **dadurch gekennzeichnet, dass** das Netzgewebe (8) einen über den Rand der Verbundscheibe (9) umlaufend hervorstehend ausgeführten Kontaktrand aufweist, der mit einem umlaufenden Kontakt zu einem leitenden Rahmen (10) verbaut ist, der eine leitende Kontaktfläche (11) mit dem Gehäuse (2) des Winkelspiegels (1) und dieser über eine leitfähige Dichtung (12) eine leitende Verbindung zu der Fahrzeughülle (13) aufweist.

10. Winkelspiegel nach Anspruch 1, **dadurch gekennzeichnet, dass** die Abschirmung aus einer auf eine Scheibe aufgebrachten transparenten stromleitenden Beschichtung besteht, die im Bereich vor der Einblicköffnung (3) und/ oder im Bereich vor der Ausblicköffnung (4) und/ oder im Strahlengang des Winkelspiegels (1;21) angeordnet ist, die über das Gehäuse (2;22) des Winkelspiegels (1;21) und eine leitfähige Dichtung (2) einen elektrisch leitenden Kontakt zur Fahrzeughülle (13) aufweist.

11. Winkelspiegel nach Anspruch 10, **dadurch gekennzeichnet, dass** die Beschichtung (18) aus einer Indium-Zinn-Oxyd-Beschichtung, einer sogenannten ITO-Beschichtung, besteht.

12. Winkelspiegel nach Anspruch 9 oder 10, **dadurch gekennzeichnet, dass** die leitfähige Dichtung (12) aus Silikon mit Nickel-Graphit besteht.

13. Winkelspiegel nach einem der vorgenannten Ansprüche, **dadurch gekennzeichnet, dass** die Oberfläche (7) des sich in den Innenraum (6) erstreckenden Teilbereichs seines Gehäuses (2) und/ oder die Oberfläche des sich aus dem Fahrzeug heraus erstreckenden Teilbereichs des Gehäuses (2) oder beiden Teilbereiche mit einer elektrisch leitfähigen Beschichtung versehen ist oder sind.

14. Winkelspiegel nach einem der vorgenannten Ansprüche, **dadurch gekennzeichnet, dass** die Oberfläche (7) des Gehäuses (2) für eine bessere Leitfähigkeit chromatiert ausgeführt ist.

15. Winkelspiegel nach einem der vorgenannten Ansprüche, **dadurch gekennzeichnet, dass** bei vor der Einblicköffnung (3) und/ oder vor der Ausblicköffnung (4) und/ oder im Strahlengang des Winkelspiegels (1;21) vorgesehenen Abschirmungen unterschiedliche Abschirmungen angeordnet sind, wie Netzgewebe (8) mit unterschiedlicher Dämpfung oder unterschiedliche transparente stromleitende Beschichtungen (18) oder Kombinationen von Netzgeweben (8) und Beschichtungen (18).
